# EUROPEAN PATENT APPLICATION

(11) **EP 4 432 280 A1**
(43) Date of publication of application: **18.09.2024**
(21) Application number: 24163622.4
(22) Date of filing: 14.03.2024
(51) Int. Cl.: G11C 5/14, G11C 7/12, G11C 11/419

(54) **NEGATIVE BIT LINE CONTROL MECHANISM**

(30) Priority: 15.03.2023 US 202363490308 P; 18.02.2024 US 202418444754
(71) Applicant: MediaTek Inc., Hsin-Chu 300 (TW)
(72) Inventor: LIAO, Weinan, 30078 Hsinchu City (TW); HUANG, Jiann-Tseng, 30078 Hsinchu City (TW)
(74) Representative: Haseltine Lake Kempner LLP

(57) **Abstract**

The present invention provides a memory device including a memory array, an IO circuitry and a control circuit. The IO circuitry includes a write buffer and a negative voltage provider. The write driver is configured to receive input data to drive bit lines of the memory array, and the negative voltage provider is configured to generate to generate a negative voltage to the write driver. The control circuit includes an NBL timing control circuit configured to generate an NBL enable signal to selectively enable the negative voltage provider. In addition, the memory device is supplied by a first supply voltage and a second supply voltage, a voltage level of the second supply voltage is higher than a voltage level of the first supply voltage, and the negative voltage provider and the NBL timing control circuit are supplied by the second supply voltage.

## Description

This application claims the benefit of U.S. Provisional Application No. 63/490,308, filed on March 15th, 2023. The content of the application is incorporated herein by reference.

### Background

A dual-rail static random access memory (SRAM) has been widely used in various chips. The dual-rail SRAM refers to an SRAM arrangement where the logic circuits are operated in a low voltage domain, while the memory array is operated in a high voltage domain. Due to this, the chip area and the power consumption can be reduced but the memory access time or memory access speed is impacted, especially the memory access time will be greatly affected if the SRAM uses an ultra-low supply voltage.

In addition, in order to improve the write ability, the SR_AM is generally designed to apply a negative voltage to a bit line of the memory array. However, since a voltage level of the negative voltage will be influenced by the supply voltage of the SR_AM, when the memory switches between two different supply voltages (e.g., the ultra-low supply voltage and a normal voltage) due to switching of operating modes, the negative voltage level will be unstable, causing writing problems to SRAM or increase the complexity of SR_AM design.

### Summary

It is therefore an objective of the present invention to provide a dual-rail memory device, which can reduce the impact of operating mode switching on the negative voltage level, to solve the above-mentioned problems.

According to one embodiment of the present invention, a memory device comprising a memory array, an IO circuitry and a control circuit is disclosed. The IO circuitry is configured to access the memory array, and the IO circuitry comprises a write buffer and a negative voltage provider. The write driver is configured to receive input data to drive bit lines of the memory array, and the negative voltage provider is configured to generate to generate a negative voltage to the write driver. The control circuit comprises a negative-bit-line (NBL) timing control circuit configured to generate an NBL enable signal to selectively enable the negative voltage provider. In addition, the memory device is supplied by a first supply voltage and a second supply voltage, a voltage level of the second supply voltage is higher than a voltage level of the first supply voltage, and the negative voltage provider and the NBL timing control circuit are supplied by the second supply voltage.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a memory device according to one embodiment of the present invention.
FIG. 2 is a diagram illustrating parts of circuit designs and the supply voltage configuration of the control circuit and the IO circuitry according to one embodiment of the present invention.
FIG. 3 shows a timing diagram of parts of the signals of the memory device according to one embodiment of the present invention.
FIG. 4 is a diagram illustrating the supply voltage configuration of the control circuit and the IO circuitry according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

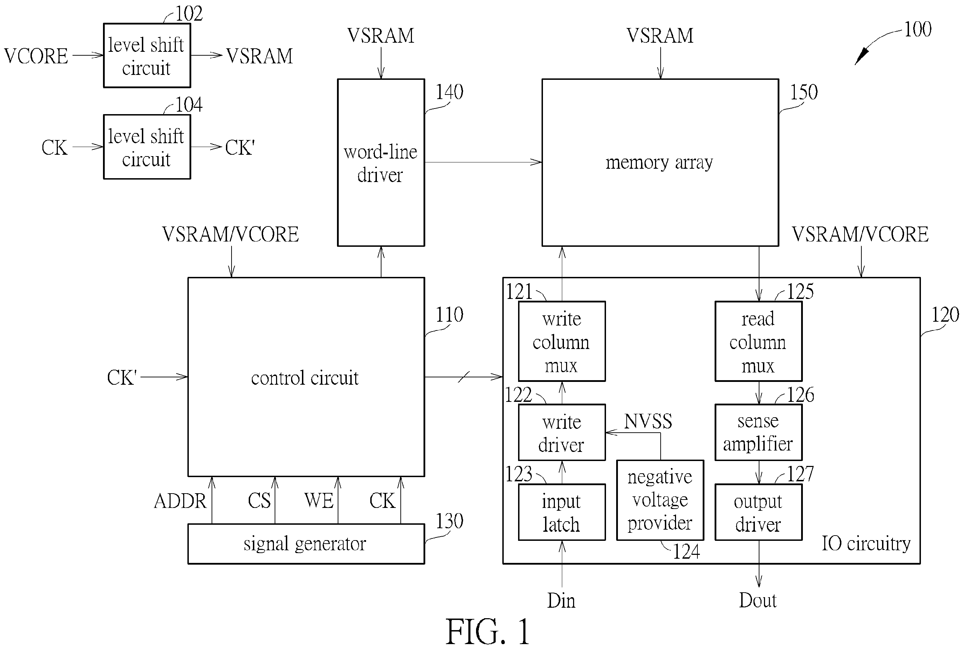

FIG. 1 is a memory device 100 according to one embodiment of the present invention. As shown in FIG. 1, the memory device 100 comprises a control circuit 110, a input/output (IO) circuitry 120, a signal generator 130, a word-line driver 140 and a memory array 150, wherein the IO circuitry 120 comprises at least a write column multiplexer (mux) 121, a write driver 122, an input latch 123, a negative voltage provider 124, a read column multiplexer 125, a sense amplifier 126 and an output driver 127. In this embodiment, the memory device 100 is a dual-rail SRAM circuitry, that is the memory device 100 uses supply voltages such as VCORE and VSRAM belonging to different power domains. In addition, the memory array 150 comprises a plurality of memory cells such as 6-transistor (6-T) SRAM cells, 8-T SRAM cells or 10-T SRAM cells.

In this embodiment, the memory device 100 can operate in a power saving mode and a normal mode, wherein the supply voltage VCORE has different voltage levels for different modes, but the supply voltage VSR_AM is always the same. Specifically, when the memory device 100 operates in the normal mode, the supply voltage VCORE has a normal voltage level such as 0.7V, and the supply voltage VSRAM has a fixed voltage level higher than 0.7V; and when the memory device 100 operates in the power saving mode, the supply voltage VCORE has a ultra-low voltage level such as 0.5V, and the supply voltage VSRAM still have the fixed voltage level.

In addition, the memory device 100 may comprise one or more level shift circuits such as 102 and 104 configured to increase voltage levels of the received signals. In one embodiment, without limitations of the present invention, the level shift circuit 102 is configured to receive the supply voltage VCORE to generate the supply voltage VSR_AM, and the level shift circuit 104 is configured to receive a clock signal CK to generate a clock signal CK' , wherein the voltage level of the supply voltage VSRAM is higher than the voltage level of the supply voltage VCORE, and the voltage level of the clock signal CK' is higher than the voltage level of the clock signal CK. In other embodiments, the supply voltage VSRAM with higher voltage level may be generated by another supply voltage generator, and the clock signal CK' with higher voltage level may be generated by another clock signal generator.

In the operation of the memory device 100, the signal generator 130 is configured to generate multiple signals for use of the control circuit 110, for example, the multiple signals may comprise an address signal ADDR, a chip select signal CS, a write enable signal WE and the clock signal CK. The control circuit 110 may comprise a read/write timing control circuit, an address latch, a column decoder, a row decoder and other circuits, and the control circuit 110 is configured to generate control signals and IO signals to the word-line driver 140 and the IO circuitry 120, respectively. The word-line driver 140 is configured to enable the word line of the memory array 150 based on the control signals generated by the control circuit 110. Regarding the IO circuitry 120, the input latch 123 is configured to receive input data Din from an external circuit. The write driver 122 is configured to receive the input data Din from the input latch 123 to write the input data into the memory array 150 via the write column multiplexer 121. The negative voltage provider 124 is configured to provide a negative voltage NVSS to the write driver 122 to improve the write ability. The sense amplifier 126 is configured to read data from the memory array 150 via the read column multiplexer 125. The output driver 127 is configured to generate output data Dout to the external circuit according to the data read by the sense amplifier 126. It is noted that the basic operations of the components within the memory device 100 are known by a person skilled in the art, and the present invention focuses on the supply voltage configurations of the memory device 100, so the detailed descriptions about the operations of the above components are omitted here.

In this embodiment, the word-line driver 140 and the memory array 150 are supplied by the supply voltage VSR_AM with higher voltage level, so that the memory array 150 has a fast access speed. The signal generator 130 is supplied by the supply voltage VCORE with lower voltage level, so that the signal generator 130 has lower power consumption and smaller chip area. The control circuit 110 is supplied by both the supply voltage VCORE and the supply voltage VSRAM, that is the control circuit 110 has a first portion supplied by the supply voltage VCORE and a second portion supplied by the supply voltage VSRAM, so that the control circuit 110 can maintain the signal transmission speed while reducing power consumption. In addition, the IO circuitry 120 is supplied by both the supply voltage VCORE and the supply voltage VSR_AM, that is the IO circuitry 120 has a first portion supplied by the supply voltage VCORE and a second portion supplied by the supply voltage VSR_AM, so that the IO circuitry 120 has the stable write ability while reducing power consumption.

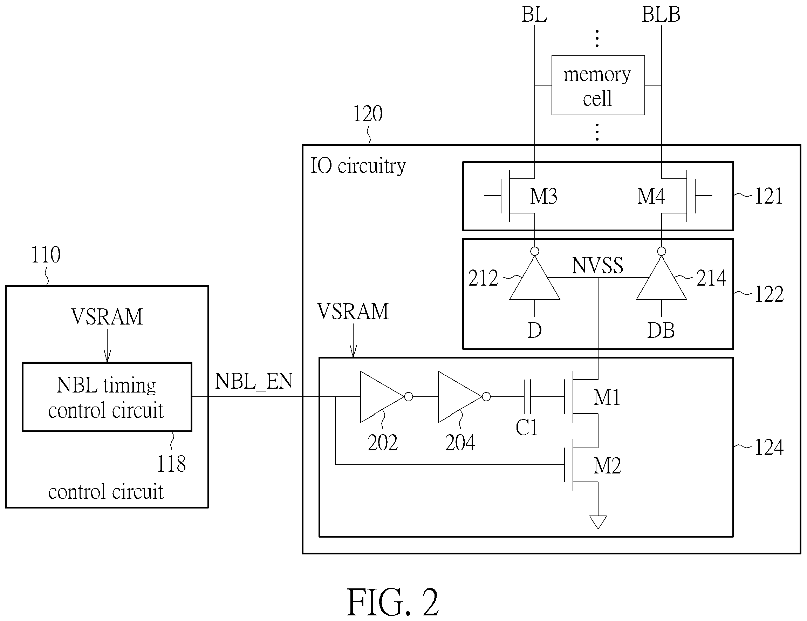

FIG. 2 is a diagram illustrating parts of circuit designs and the supply voltage configuration of the control circuit 110 and the IO circuitry 120 according to one embodiment of the present invention. As shown in FIG. 2, the control circuit 110 comprises a negative-bit-line (NBL) timing control circuit 118, wherein the NBL timing control circuit 118 is configured to generate an NBL enable signal NBL_EN to selectively enable the negative voltage provider 124 to generate the negative voltage NVSS to the write driver 122. The negative voltage provider 124 comprises two inverters 202, 204, a capacitor C1 and two transistors M1 and M2, wherein the transistor M1 is controlled by the NBL enable signal NBL_EN passing through the inverters 202, 204 and the capacitor C1, and the transistor M2 is controlled by the NBL enable signal NBL_EN, to selective provide the negative voltage NVSS to the write driver 122. The write driver 122 comprises two drivers 212 and 214, and the write column multiplexer 121 comprises two transistors M3 and M4 serving as two switches, wherein the drivers 212 and 214 receives the data D and DB generated from the input latch 123 to drive the bit-lines BL and BLB via the transistors M3 and M4, respectively. It is noted that FIG. 2 only shows part of circuits of the write column multiplexer 121, the write driver 122 and the negative voltage provider 124, and because the operations of circuit designs of the write column multiplexer 121, the write driver 122 and the negative voltage provider 124 are known by a person skilled in the art, other examples are not provided here.

In the embodiment shown in FIG. 2, the NBL timing control circuit 118 within the control circuit 110 is supplied by the supply voltage VSRAM, and the negative voltage provider 124 within the IO circuitry 120 is also supplied by the supply voltage VSRAM, so the bit line BL/BLB will have stable negative voltage regardless of whether the memory device 100 is operating in the normal mode or the power saving mode (i.e., regardless of whether the supply voltage VCORE has normal voltage level or ultra-low voltage level) . Therefore, the memory device 100 can have stable write ability at ultra-low voltage without additional circuit designs.

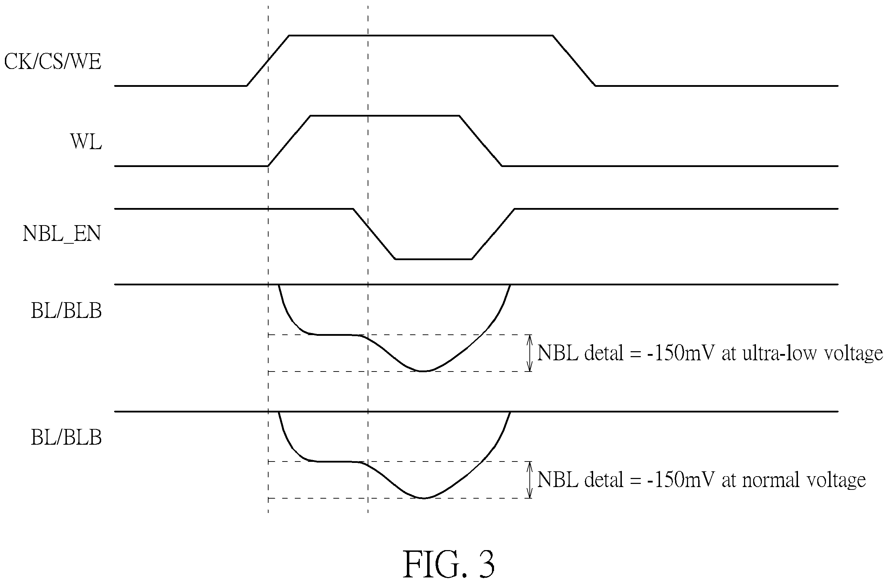

FIG. 3 shows a timing diagram of parts of the signals of the memory device 100 according to one embodiment of the present invention. When the memory device 100 starts to write data into the memory array 150, the clock signal CK, the chip select signal CS and the write enable signal WE is enabled so that the word line (WL) is enabled. Then, the NBL timing control circuit 118 generates the NBL enable signal NBL_EN to enable the negative voltage provider 124 to generate the negative voltage NVSS to the write driver 122, to make the bit line BL or BLB has the negative voltage. In addition, regardless of whether the supply voltage VCORE has normal voltage level or ultra-low voltage level, the bit line BL/BLB will always have similar negative voltage level.

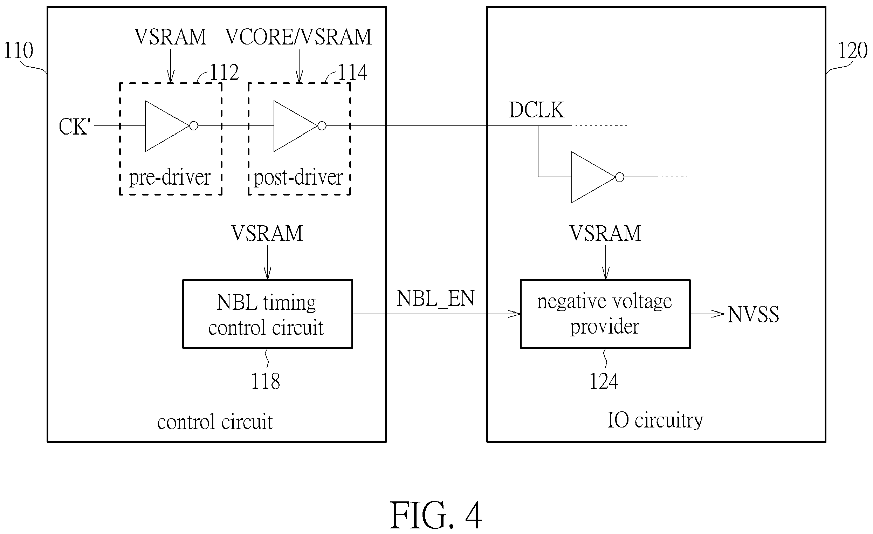

FIG. 4 is a diagram illustrating the supply voltage configuration of the control circuit 110 and the IO circuitry 120 according to one embodiment of the present invention. As shown in FIG. 4, the control circuit 110 comprises a pre-driver 112, a post-driver 114 and the timing control circuit 118, wherein the pre-driver 112 receives a signal to generate a processed signal, and the post-driver 114 receives the processed signal to generate a global IO signal to the IO circuitry 120. In this embodiment, without limitations of the present invention, the pre-driver 112 is implemented by using an inverter, and the post-driver 114 is also implemented by an inverter, the clock signal CK' serves as the signal inputted into the pre-driver 112, and an output clock signal DCLK serves as the global IO signal. In other embodiments, the pre-driver 112 may comprise more than one inverters connected in series, and the post-driver 114 may comprise more than one inverters connected in series.

In the embodiment shown in FIG. 4, the pre-driver 112 is supplied by the supply voltage VSR_AM with higher voltage level, and the post-driver 114 is supplied by the supply voltage VCORE with lower voltage level. Because the pre-driver 112 is supplied by the supply voltage VSR_AM, an output signal of the pre-driver 112 will have higher voltage level, so that the post-driver 114 can generate the output clock signal DCLK with faster speed. Specifically, when the clock signal CK' has a low voltage level, the output signal of the inverter within the pre-driver 112 will have a high voltage level; and because the output signal of the inverter has the high voltage level such as VSRAM, an N-type transistor within the inverter of the post-driver 114 will be enabled with higher current, so that the post-driver 114 can generate the output clock signal DCLK having the low voltage level (e.g., 0V or ground voltage) in a short time. In addition, because the control circuit 110 generates the output clock signal DCLK with faster speed, a hold time will be shortened when the input latch 128 uses the output clock signal DCLK to sample the input signal Din.

In addition, the output clock signal DCLK is inputted into the IO circuitry 120, for use of the multiple components such as the input latch 128, the output driver 129, or the sense amplifier 126. That is, the IO circuitry 120 may have multiple paths, such as the inverters shown in FIG. 2, for receiving the output clock signal DCLK.

In the embodiment shown in FIG. 4, the pre-driver 112 receives the clock signal CK' that is generated by level-shifting the clock signal CK. However, in other embodiments, the pre-driver 112 can receive the clock signal CK having lower voltage level.

In the above embodiment shown in FIG. 4, the pre-driver 112 and the post-driver 114 are supplied by using different supply voltages, however, the present invention is not limited to this. In another embodiment, the pre-driver 112 and the post-driver 114 can be supplied by the same supply voltage VSRAM, or all the components within the control circuit 110 are supplied by the supply voltage VSRAM. These alternative designs shall fall within the scope of the present invention.

In one embodiment, the negative voltage provider 124 within the IO circuitry 120 is supplied by the supply voltage VSRAM to stabilize the negative voltage level, and the other components such as the write driver 122, the input latch 123, the sense amplifier 126 and/or the output driver 127 is/are supplied by the supply voltage VCORE to lower the power consumption, so the memory device 100 can always have the stable write ability while maintaining low power consumption.

Briefly summarized, in the memory device of the present invention, by designing the NBL timing control circuit and the negative voltage provider to be supplied by the supply voltage VSRAM that has a fixed voltage level, the memory device can always have stable write ability regardless whether the memory device operates in the normal mode or a power saving mode. In addition, by designing the other components within the IO circuitry to use the supply voltage VCORE with lower voltage level, the memory device 100 can have the stable write ability while maintaining low power consumption.

Those skilled in the art will readily observe that numerous modifications and alterations of the device and method may be made while retaining the teachings of the invention. Accordingly, the above disclosure should be construed as limited only by the metes and bounds of the appended claims.

The present invention may also be defined by the following numbered clauses.
1. A memory device, comprising:
   a memory array;
   an input/output (IO) circuitry, configured to access the memory array, wherein the IO circuit comprises:
      a write driver, configured to receive input data to drive bit lines of the memory array; and
      a negative voltage provider, configured to generate to generate a negative voltage to the write driver; and
   a control circuit, comprising:
      a negative-bit-line (NBL) timing control circuit, configured to generate an NBL enable signal to selectively enable the negative voltage provider;
   wherein the memory device is supplied by a first supply voltage and a second supply voltage, and a voltage level of the second supply voltage is higher than a voltage level of the first supply voltage; and the negative voltage provider and the NBL timing control circuit are supplied by the second supply voltage.
2. The memory device of clause 1, wherein when the memory array operates in a normal mode, the first supply voltage has a normal voltage level; and when the memory operates in a power saving mode, the first supply voltage has a low voltage level different from the normal voltage level; and the second supply voltage has the same voltage level regardless whether the memory device operates in the normal mode or the power saving mode.
3. The memory device of clause 1, wherein the IO circuitry further comprises a sense amplifier, an input latch and an output driver, and at least one of the write driver, the sense amplifier, the input larch and the output driver is supplied by the first supply voltage.
4. The memory device of clause 1, wherein the control circuit is supplied by both the first supply voltage and the second supply voltage.
5. The memory device of clause 4, wherein the control circuit comprises a pre-driver and a post-driver, the pre-driver is supplied by the second supply voltage, and the post-driver is supplied by the first supply voltage.
6. The memory device of clause 5, wherein the pre-driver receives a clock signal to generate a processed signal, and the post-driver receives the processed signal to generate an output clock signal serving as the global IO signal to the IO circuitry.
7. The memory device of clause 5, further comprising:
   a signal generator supplied by the first supply voltage, configured to generate a first clock signal; and
   a level shift circuit, configured to receive the first clock signal to generate the clock signal, wherein a voltage level of the clock signal is higher than a voltage level of the first clock signal.
8. The memory device of clause 5, wherein each of the pre-driver and the post-driver comprises an inverter.
9. The memory device of clause 1, wherein the memory device is a dual-rail static random access memory (SRAM) circuitry.

## Claims

1. A memory device (100), comprising:
a memory array (150);
an input/output, IO, circuitry (120), configured to access the memory array (150), wherein the IO circuit comprises:
a write driver (122), configured to receive input data to drive bit lines of the memory array (150); and
a negative voltage provider (124), configured to generate to generate a negative voltage to the write driver (122); and
a control circuit (110), comprising:
a negative-bit-line, NBL, timing control circuit (110), configured to generate an NBL enable signal to selectively enable the negative voltage provider (124);
wherein the memory device (100) is supplied by a first supply voltage and a second supply voltage, and a voltage level of the second supply voltage is higher than a voltage level of the first supply voltage; and the negative voltage provider (124) and the NBL timing control circuit (118) are supplied by the second supply voltage.

2. The memory device (100) of claim 1, wherein when the memory array (150) operates in a normal mode, the first supply voltage has a normal voltage level; and when the memory operates in a power saving mode, the first supply voltage has a low voltage level different from the normal voltage level; and the second supply voltage has the same voltage level regardless whether the memory device (100) operates in the normal mode or the power saving mode.

3. The memory device (100) of claim 1 or claim 2, wherein the IO circuitry (120) further comprises a sense amplifier (126), an input latch (123, 128) and an output driver (127, 129), and at least one of the write driver (122), the sense amplifier (126), the input larch and the output driver (127, 129) is supplied by the first supply voltage.

4. The memory device (100) of claim 1, wherein the control circuit (110) is supplied by both the first supply voltage and the second supply voltage.

5. The memory device (100) of claim 4, wherein the control circuit (110) comprises a pre-driver (112) and a post-driver (114), the pre-driver (112) is supplied by the second supply voltage, and the post-driver (114) is supplied by the first supply voltage.

6. The memory device (100) of claim 5, wherein the pre-driver (112) receives a clock signal to generate a processed signal, and the post-driver (114) receives the processed signal to generate an output clock signal serving as the global IO signal to the IO circuitry (120).

7. The memory device (100) of claim 5 or claim 6, further comprising:
a signal generator (130) supplied by the first supply voltage, configured to generate a first clock signal; and
a level shift circuit (102, 104), configured to receive the first clock signal to generate the clock signal, wherein a voltage level of the clock signal is higher than a voltage level of the first clock signal.

8. The memory device (100) of any one of claims 5 to 7, wherein each of the pre-driver (112) and the post-driver (114) comprises an inverter.

9. The memory device (100) according to any one of the preceding claims, wherein the memory device (100) is a dual-rail static random access memory, SRAM, circuitry.
